# EUROPEAN PATENT APPLICATION

(11) **EP 1 811 579 A1**
(43) Date of publication of application: **25.07.2007**
(21) Application number: 06425019.4
(22) Date of filing: 18.01.2006
(51) Int. Cl.: H01L 31/173, H01L 27/32

(54) **Galvanic optocoupler structure and corresponding hybrid integration process**

(71) Applicant: STMicroelectronics S.r.l., 20041 Agrate Brianza (Milano) (IT)
(72) Inventor: Guerra, Ranieri, I-13386 Cossato (IT); Leonardi, Salvatore, I-95025 Aci S. Antonio (Catania) (IT)
(74) Representative: Ferrari, Barbara

(57) **Abstract**

A galvanic optocoupler structure (10) of the type comprising at least one optical source (3) coupled to an optical detector (5) and separated therefrom by a transmission means (4) of an optical signal is described. Advantageously, the optical source (3) is realised by means of an organic LED comprising a optical substrate (4) transparent with respect to the optical signal and associated directly with the optical detector (5) to serve as transmission and insulation means (4) between the optical source (3) and the optical detector (5).

The hybrid integration process of such a galvanic optocoupler structure is also described.

## Description

### Field of application

The present invention relates to a galvanic optocoupler structure.

More specifically, the invention relates to a galvanic optocoupler structure of the type comprising at least one optical source coupled to an optical detector and separated thereform by a transmission means of an optical signal.

The invention also relates to a hybrid integration process of such a galvanic optocoupler structure.

The invention particularly, but not exclusively, relates to a galvanic optocoupler structure comprising at least one organic LED (Light Emitting Diode) and suitable for being monolithically integrated and the following description is made with reference to this field of application by way of illustration only.

### Prior art

As it is well known, a galvanic coupler is a so called dual-port device able to transfer a signal between a first and a second circuit node of a system, ensuring, between the same, a certain galvanic insulation level and several electronic systems currently on sale require, inside themselves, the use of this type of couplers.

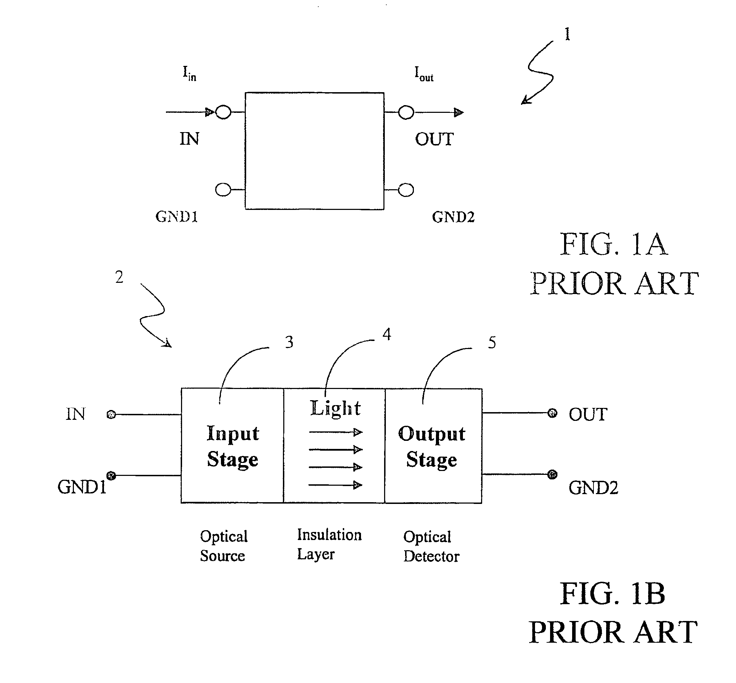

A galvanic coupler of the known type is schematically shown in Figure 1, globally indicated with 1. In particular, the galvanic coupler 1 connects a first circuit node, or input IN, to a second circuit node, or output OUT, for the transmission of a current signal, ensuring the galvanic insulation of the respective voltage references GND 1 and GND2.

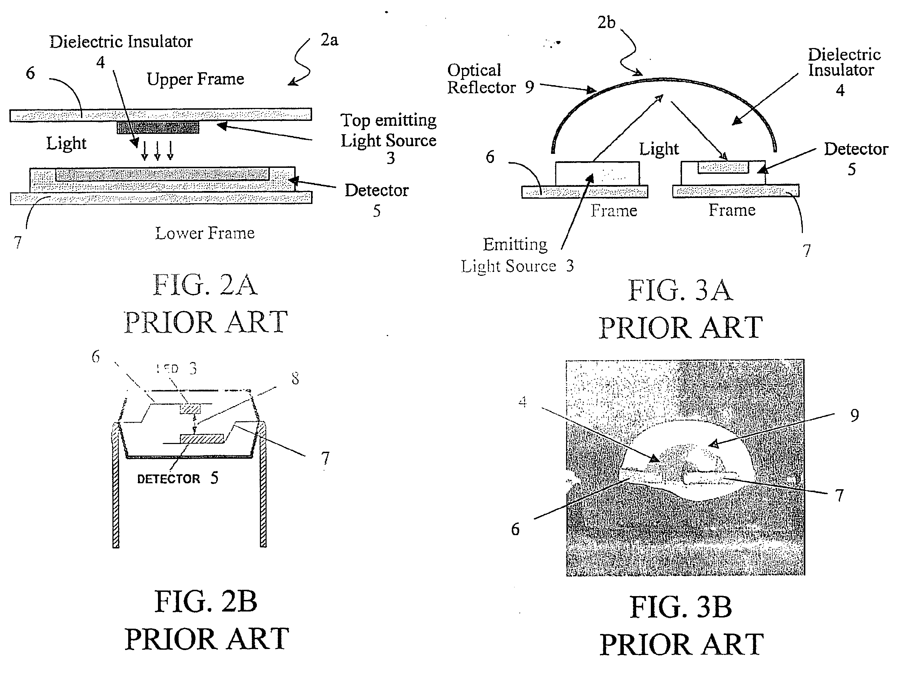

A standard solution to obtain the functionality of current transfer and of galvanic insulation of the voltage references a galvanic coupler is required consists in realizing it by means of an optoelectronic component, as the galvanic optocoupler schematically shown in Figure 2 and globally indicated with 2.

The galvanic optocoupler 2 connects a first circuit node, or input IN, to a second circuit node, or output OUT, ensuring the galvanic insulation of the respective voltage references GND1 and GND2 thanks to the conversion of an input electric signal into an optical signal.

In particular, the galvanic optocoupler thus comprises an input stage 3 made up of an optical source connected, by means of an intermediate stage 4 realised by a transmission means, in particular an insulation layer, to an output stage 5 made up of an optical detector. In particular, the insulation layer of the intermediate stage 4 is a means suitable for transmitting an optical signal (indicated with Light in the figure).

More in particular, the input optical source or transmitter emits a power which is transferred to the optical detector or output photodetector: in this way, if the transmission means through which transmitter and photodetector communicate has a good transparency and a good electric insulation degree, the galvanic optocoupler 2 fully realises the functionality of transmission and simultaneous insulation requested.

The galvanic optocouplers are components being commonly used in the electronics at the "consumer" level and therefore they are available in a wide range of solutions which mainly differ for the insulation specifications ensured and for the switch speed. The structures realising these galvanic optocouplers are essentially requested to be little expensive and of simple realisation.

The optical sources used are usually LED diodes realised on substrates III-V which are interfaced and assembled with silicon phototransistors, which realise the optical detectors. Two fundamental assembly architectures are known being suitable for realising a galvanic optocoupler, as shown in Figures 2A-2B and 3A-3B and hereafter described.

In particular, Figure 2A schematically shows a so called Face-to-Face assembly architecture for realising a galvanic optocoupler, globally indicated with 2a.

In this first type of assembly architecture the optical source and detector are interfaced directly by a transmission means, in particular a transparent dielectric insulation means so as to ensure the maximum optical coupling.

In particular, the galvanic optocoupler 2a comprises a first frame 6 of the optical source 3 placed in front of a second frame 7 of the optical detector 5 and separated therefrom by a transmission means 4, specifically a dielectric insulation layer, the optical signal Light being transmitted from the optical source 3 to the optical detector 5 through the transmission means 4 which is transparent.

A galvanic optocoupler realised according to this first type of assembly architecture is shown in Figure 2B, where a fundamental parameter of this type of architecture has been indicated, i.e. the distance 8 between source and detector.

Although advantageous under several aspects, the assembly architectures of the Face-to-Face type have the main disadvantage of requiring two distinct frames for the optical source 3 and for the optical detector 5, which must be realised and placed in an extremely precise way to ensure the correct transfer of the optical signal.

Galvanic optocouplers with the assembly of the Face-to-Face type which try to solve only partially these problems are for example described in the US patents No. 5654559 and No. 6509574. In particular, the first patent describes a galvanic optocoupler comprising a source in GaAs of the IRED type superficially mounted on a photodetector while the second patent relates to a source of the OLED type directly integrated on a transparent insulation layer of reduced size (some micrometres), no contact terminal being provided besides this integrated structure.

A second type of assembly architecture provides instead the positioning of the optical source 3 and of the optical detector 5 on respective coplanar frames 6 and 7 and the use of an optical reflector 9, for the suitable reflection of the optical signal Light.

In this second type of assembly architecture of a galvanic optocoupler, schematically shown in Figure 3A and globally indicated with 2b, the optical power emitted by the optical source 3 is reflected and conveyed onto the optical detector 5 thanks to the use of the optical reflector or mirror 9. Also in this case the transmission means 4, which fills in the space between the optical reflector 9 and the frames 6 and 7, is an insulating dielectric with good characteristics of transparency.

A galvanic optocoupler realised according to this second type of assembly architecture is shown in Figure 3B where the optical reflector 9 is integrated in a package.

Although meeting the aim, this prior art solution is not exempt from drawbacks, the main of which is linked to the realisation of the optical reflector 9 and to the relative additional burdens for the galvanic optocoupler, which is, as already said, an element being requested an extreme competitiveness in terms of costs.

The technical problem underlying the present invention is that of providing a structure to realise a galvanic optocoupler having such structural and functional characteristics as to ensure a correct transmission of an optical signal and a correct galvanic insulation although maintaining the realisation costs of the optocoupler itself limited and the relative assembly procedures simple, overcoming the limits and drawbacks still affecting the prior art architectures.

### Summary of the invention

The solution idea underlying the present invention is that of using, as optical source, an organic LED in a monolithic structure able to exploit the structural characteristics thereof so as to obtain a galvanic optocoupler being simpler in terms of assembly, less expensive and equally functional with respect to the known architectures.

On the basis of this solution idea the technical problem is solved by a galvanic optocoupler structure as previously indicated and defined by the characterising part of claim 1.

The problem is also solved by a hybrid integration process of a galvanic optocoupler structure of the type defined by the characterising part of claim 24.

The characteristics and the advantages of the galvanic optocoupler structure and of the hybrid integration process according to the invention will be apparent from the following description of an embodiment thereof given by way of indicative and non limiting example with reference to the annexed drawings.

### Brief description of the drawings

In these drawings:
Figure 1A schematically shows a galvanic coupler realised according to the prior art;
Figure 1B schematically shows a galvanic optocoupler realised according to the prior art;
Figures 2A and 2B schematically show a first type of assembly architecture of a galvanic optocoupler realised according to the prior art;
Figures 3A and 3B schematically show a second type of assembly architecture of a galvanic optocoupler realised according to the prior art;
Figure 4 schematically shows a galvanic optocoupler structure realised according to the invention;
Figures 5A and 5B schematically show an optical source comprised in the galvanic optocoupler structure of Figure 4;
Figure 6 shows, in greater detail, the galvanic optocoupler structure of Figure 4;
Figures 7A-7C schematically show possible circuit configurations of the optical detector comprised in the galvanic optocoupler structure of Figure 4.

### Detailed description

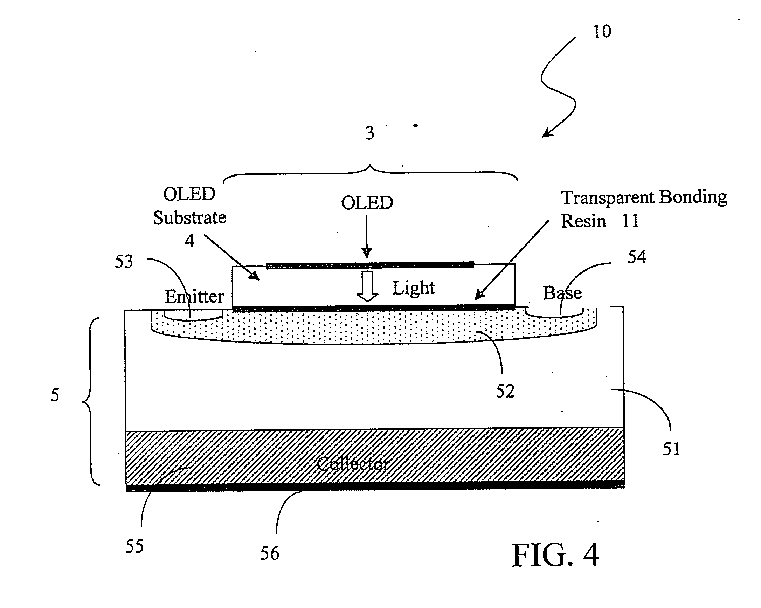

With reference to these figures, and in particular to Figure 4, 10 globally and schematically indicates a galvanic optocoupler structure realised according to the invention.

Elements being structurally and/or functionally identical to the architectures described with reference to the prior art will be given the same reference numbers for sake of simplicity.

The galvanic optocoupler structure 10 thus comprises an optical source 3 coupled to an optical detector 5 and separated therefrom by a transmission means 4, substantially according to an assembly architecture of the Face-to-Face type as previously described with reference to the prior art.

Advantageously according to the invention, the optical source 3 is realised by means of an organic LED, or OLED. It is to be noted that the use of an optical source 3 of the OLED type, whose development in the recent years has had a strong boost, allows to maintain the realisation costs of the galvanic optocoupler structure 10 according to the invention at a reasonable level, thanks to the low cost of the organic materials with respect to the crystalline materials used in silicon-integrated devices.

Moreover, advantageously according to the invention, the galvanic optocoupler structure 10 is monolithically integrated and thus allows to use realisation processes being already known in the field of the microelectronics, simplifying the assembly procedures of the proposed galvanic optocoupler structure, as it will be clear hereafter in the description.

In substance, the galvanic optocoupler structure 10 comprises an optical source 3 realised by means of an OLED and directly glued on a monolithically integrated optical detector 5, thanks to a suitable adhesive material 11, such as a transparent bonding resin. Suitably, the OLED 3 comprises a transparent optical substrate suitable for serving as transmission means 4 wherein the optical signal Light generated by the OLED 3 is transmitted to the optical detector 5.

In particular, the optical detector 5 comprises a structure integrated on a semiconductor substrate 51 wherein an active region 52 is realised. In the example shown in Figure 4, the optical detector 5 is a phototransistor comprising respective emitter 53 and base 54 regions realised in the active region 52, as well as a deep collector region 55 realised in this semiconductor substrate 51 and contacted at the back by means of a contacting layer 56. Also the emitter 53 and base 54 regions have suitable contact areas for the connection through bonding, not shown in the figure.

Advantageously according to the invention, the OLED 3 is mounted directly on the active region 52 of the phototransistor 5, in a portion devoid of these emitter and base regions, 53 and 54, and it is directly glued thereon by means of the transparent bonding resin 11. In an embodiment, the OLED 3 is connected to the active region 52 of the phototransistor 5 by other connection means, for example through bonding.

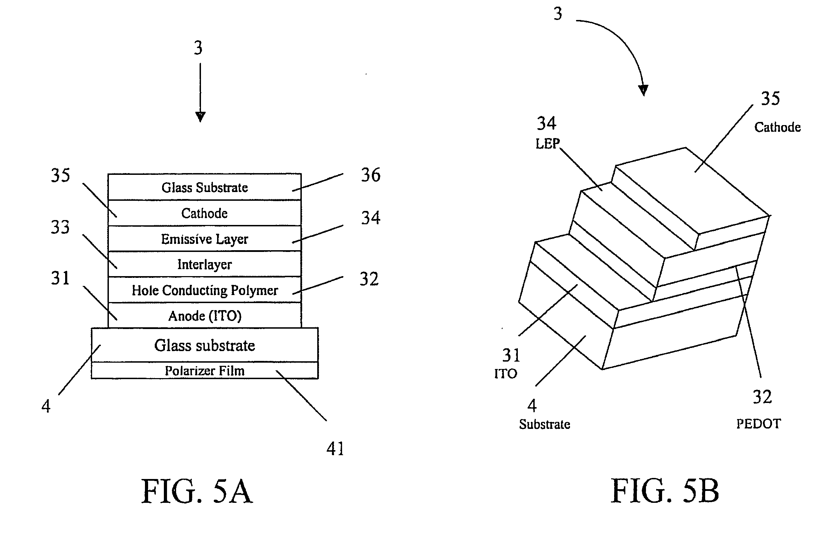

A typical structure for an optical source 3 of the OLED type is shown in Figures 5A and 5B and it is made up of an optically emissive organic multilayer, electrically supplied and encapsulated by two electrodes - commonly indicated as cathode and anode - of which at least one is transparent.

The OLED 3 thus comprises a transparent optical substrate 4 whereon a polarising layer 41 is realised suitable for imposing a particular colour onto the light emitted by the OLED itself.

In a preferred embodiment, the OLED 3 comprises a transparent anode 31, realised by means of an ITO layer directly above the optical substrate 4 whereon a hole carrying layer 32 (for example a PEDOT layer) and possibly an intermediate layer 33 as well as an emissive layer 34, such as a LEP layer, are realised in succession.

The OLED 3 is completed on top by a cathode 35 whereon a further transparent layer 36 is possibly realised.

Advantageously, the optical substrate 4 is realised by an electrically insulating and optically transparent (such as glass) material and it is used by the galvanic optocoupler structure 10 according to the invention and both as transmission means 4 of the luminous signal Light and as insulation layer between the OLED 3 and the optical detector 5.

In substance, advantageously according to the invention, a galvanic optocoupler is realised by means of direct gluing or bonding of the optical source 3 onto the optical detector 5 (which can be realised both at the chip level and possibly at the wafer level), obtaining, as a single component, the monolithically assembled galvanic optocoupler structure 10 above described, where the OLED 3 emits lights exactly through its optical substrate 4 which is directly interfaced on the optical detector 5.

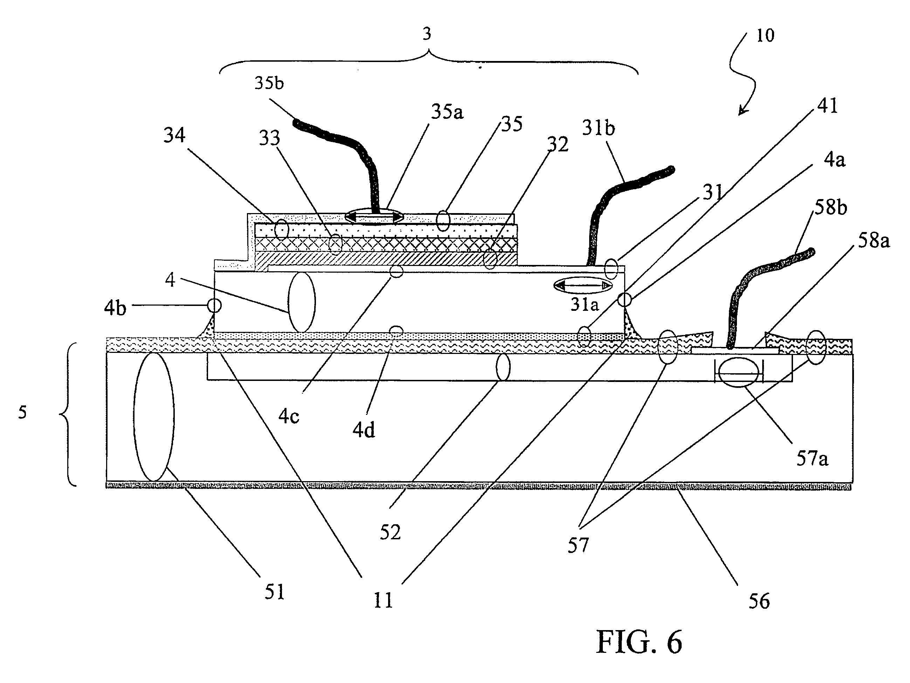

The galvanic optocoupler structure 10 according to the invention is shown in greater detail in Figure 6. The galvanic optocoupler structure 10 is substantially a monolithic block obtained by hybrid integration of the OLED 3 directly onto the optical detector 5, in the example shown a photodiode.

In particular, the galvanic optocoupler structure 10 comprises a semiconductor substrate 51, in particular of silicon, having at least one active region 52 able to generate a photocurrent.

Above the semiconductor substrate 51 and of the active region 52 a passivation layer 57 is realised, provided with suitable discontinuities 57a in correspondence with the active region 52 where it is possible to realise metallic pads 58a for the contact of this active region 52, for example through bonding wires 58b.

The passivation layer 57 is typically a passivating dielectric material such as SiO2, SiON, Si3N4 or SiNH and it is used for the protection of the optical detector 5. In its more general form, it can be thus said that the layer 57 is a protection layer of the optical detector 5.

In the back position, the semiconductor substrate 51 also comprises the contacting layer 56.

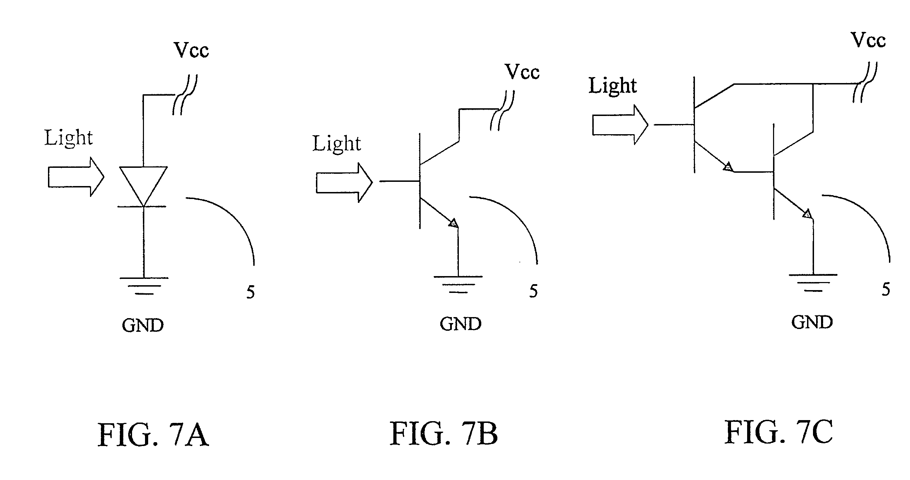

Thus the optical detector 5 is realised in the form of a photodiode, as shown in Figure 7A by means of its circuit equivalent. It is also possible to configure - in a way being known by the technician of the field - the optical detector 5 as a phototransistor, providing suitable base, emitter and collector regions, as briefly described with reference to Figure 4 or a photodarlington, comprising at least one first and one second transistor connected in Darlington configuration, as schematically shown by means of the circuit equivalents in Figures 7B and 7C.

Advantageously according to the invention, the galvanic optocoupler structure 10 also comprises at least one mechanical connection means of the optical source 3 to the optical detector 5. In particular, in the example shown in Figure 6, the galvanic optocoupler structure 10 comprises an adhesive material 11, in particular a transparent bonding resin for the gluing of the optical source 3 above the passivation layer 57 in correspondence with the active region 52, in distinct a position with respect to the discontinuity 57a.

It is to be noted that the semiconductor substrate 51 serves as mechanical frame of the optical source 3.

In particular, as above described, the optical source 3 comprises an optical substrate 4 serving as transmission means, having a first 4a, a second 4b, a third 4c and a fourth 4d peripheral interconnection areas between optical source 3 and optical detector 5 of the galvanic optocoupler structure 10. In a preferred embodiment, the transparent bonding resin 11 is present in correspondence with the fourth peripheral area 4d, i.e. in correspondence with the rest area of the optical source 3 on the optical detector 5. This transparent bonding resin 11 can further laterally interconnect the first 4a and the second peripheral area 4b to the passivation area 57 of the optical detector 5.

More in detail, the fourth peripheral area 4d is in contact with a polarising layer 41, in turn in contact with the passivation area 57 of the optical detector 5, while the third peripheral area 4c is in contact with the anode 31 having at least one metallic pad 31a for its contacting, for example by means of bonding wires 31b.

In particular, the anode 31 is realised in a transparent material, typically ITO, while the polarising layer 41 is chosen so as to select the wave length of the light emitted by the optical source 3.

In a further embodiment, it is possible to provide suitable contact vias between the optical substrate 4 of the optical source 3 and the optical detector 5.

Above the anode 31 the hole carrying layer 32 is then realised, having at least one portion in contact with the optical substrate 4, possibly the intermediate layer 33 and the emissive layer 34.

Advantageously according to the invention, the emissive layer 34 is an organic or polymeric layer suitable for realising the light emission, i.e. the optical signal Light emission.

The galvanic optocoupler structure 10 is completed by a cathode 35, having at least one portion in contact with the optical substrate 4, as well as at least one metallic pad 35a for its contacting, for example by means of bonding wires 35b.

In a further embodiment, the metallic pad 35a for contacting the cathode 35 is realised in the lateral portion of this cathode 35 in direct contact with the optical substrate 4, the insulation between the anode 31 and the cathode 35 being ensured by the portion of the hole carrying layer 32 in direct contact with the optical substrate 4.

Advantageously according to the invention, the galvanic optocoupler structure 10 is obtained by means of a hybrid integration process of the OLED 3 directly onto the optical detector 5 essentially comprising the following steps:
- realising an optical detector 5 provided with at least one active region 52 for the generation of a photocurrent;
- realising an optical source 3 on an optical substrate 4; and
- mechanically associating the optical source 3 with this active region 52 of the optical detector 5,
the optical substrate 4 serving in this way as transmission means of the optical signal Light from the optical source 3 to the optical detector 5 of the galvanic optocoupler structure 10 thus obtained.

More in particular, in a preferred embodiment of the hybrid integration process of the galvanic optocoupler structure 10 according to the invention, the step of mechanically associating the optical source 3 with the optical detector 5 comprises a step of gluing this optical source 3 and this optical detector 5 by means of an adhesive material 11, typically a transparent bonding resin.

According to the invention, the step of realising the optical detector 5 comprises the steps of:
- realising, in a semiconductor substrate 51, at least the active region 52 for the generation of a photocurrent of the optical detector 5; and
- realising, on the semiconductor substrate 51 and the active region 52, a protection layer 57, in particular of passivation, provided with suitable discontinuities 57a.

Further, the step of realising the optical source 3 comprises the step of realising, on the optical substrate 4, at least one anode 31 and one cathode 35 of the optical source 3 which enclose at least one emissive layer 34 of an optical source Light.

Advantageously according to the invention, the hybrid integration process also comprises the steps of:
- positioning the optical substrate 4 of the optical source 3 on this passivation layer 57 in a distinct position with respect to the discontinuities 57a; and
- associating, through gluing, the optical substrate 4 to with the passivation layer 57 by means of an adhesive material 11, such as a transparent bonding resin.

The hybrid integration process according to the invention also comprises at least one shaping step of the optical substrate 4 of the optical source 3 suitable for realising at least one first and one second peripheral area, 4a and 4b, interconnected to the passivation layer 57 by means of the transparent bonding resin 11, as well as a third and a fourth peripheral area, 4c and 4d, the fourth peripheral area 4d being contacted, possibly by means of a polarising layer 41, by the passivation layer 57 of the optical detector 5, and the third peripheral area 4c being contacted by the anode 31.

The step of realising, on the optical substrate 4, the optical source 3 also comprises the steps of:
- realising the anode 31 directly above the optical substrate 4;
- realising a hole carrying layer 32 on the anode 31 and having at least one portion in contact with the optical substrate 4;
- realising the emissive layer 34 above the hole carrying layer 32;
- realising the cathode 35 on the emissive layer 34 and having at least one portion in contact with the optical substrate 4.

The hybrid integration process can also comprise a step of realising an intermediate layer 33 between the hole carrying layer 32 and the emissive layer 34.

In a preferred embodiment of the hybrid integration process according to the invention, the step of realising the emissive layer 34 comprises a step of depositing an organic or polymeric layer suitable for realising the emission of an optical signal.

Advantageously according to the invention, the step of realising the hole carrying layer 32 on the anode 31 is carried out so as not to overlap onto at least one portion of this anode 31.

The hybrid integration process thus comprises a step if realising suitable metallic pads, 31a and 35a, on the anode 31 and on the cathode 35 of the optical source 3, for their contacting, for example by means of respective bonding wires, 31b and 35b, as well as a step of realising suitable metallic pads 58a in correspondence with the discontinuities 57a of the passivation layers 57 for the contacting of the active region 52 of the optical detector 5, for example by means of bonding wires 58a.

It is to be noted that the process steps described do not form a complete process flow for the integration of the galvanic optocoupler structure 10. The present invention can be put into practice together with the manufacturing techniques of the integrated circuits and of the optical devices currently used in the field, and only those process steps being necessary for the comprehension of the present invention have been included.

Moreover, the figures showing schematic views of portions of the galvanic optocoupler structure 10 are not drawn to scale, but they are instead drawn so as to emphasise the important characteristics of the invention.

It is to be noted that it is essential that the optical substrate 4 of the optical source 3 shows a good optical transparency and is electrically insulating as it normally occurs for devices such as the OLED.

Moreover, it is to be noted that the optical source 3 and the optical detector 5 of the galvanic optocoupler structure 10 according to the invention are sized in an adequate way so that:
1. the optical signal Light emitted by the emissive layer 34 of the optical source 3, after the passage through the optical substrate 4, serving as transmission means, ends inside the active region 52 of the optical detector 5;
2. an area is reserved, in particular the discontinuity 57a, for electrically contacting the optical detector 5, by means of suitable shaping of the optical source 3;
3. cathode 35 and anode 31 of the optical source 3 can be electrically contacted in a direct way, for example by means of bonding wires (31b, 35b), suitable areas (31a, 35a) being reserved for this contacting on at least one exposed side of the optical source 3.

In conclusion, advantageously according to the invention, a galvanic optocoupler structure has been described obtained in a simple way by gluing an optical source 3 onto an optical detector 5 in a hybrid integration process providing the separate realisation of the optical source 3 and of the optical detector 5.

In this way, both the optical source 3 and the optical detector 5 have sizes corresponding to the elements currently on sale and they can be realised with the techniques already known in the field.

The galvanic optocoupler structure 10 according to the invention allows to ensure a correct transmission of an optical signal and a correct galvanic insulation although having limited realisation costs. In particular, advantageously according to the invention, the galvanic optocoupler structure 10 uses, as optical source, an organic LED in a monolithic structure able to exploit its structural characteristics and in particular using the optical substrate both as signal transmission means and as insulation layer between the optical source 3 and the optical detector 5. The galvanic optocoupler structure described is also remarkably simple in terms of assembly and much less expensive with respect to the structures known in the field thanks to the use of organic materials.

## Claims

1. Galvanic optocoupler structure (10) of the type comprising at least one optical source (3) coupled to an optical detector (5) and separated therefrom by a transmission means (4) of an optical signal, **characterised in that** said optical source (3) is realised by means of an organic LED comprising an optical substrate (4) being transparent with respect to said optical signal and associated directly with said optical detector (5) to serve as transmission and insulation means (4) between said optical source (3) and said optical detector (5).

2. Galvanic optocoupler structure (10) according to claim 1, **characterised in that** it comprises at least one adhesive material (11) suitable for mechanically associating said optical source (3) and said optical detector (5).

3. Galvanic optocoupler structure (10) according to claim 1, **characterised in that** said optical detector (5) comprises a structure integrated on a semiconductor substrate (51) wherein at least one active region (52) is realised provided with at least one contact portion (58a), said optical source (3) being positioned directly on said active region (52), in a portion devoid of said contact portion (58a), said active region (52) being able to generate a photocurrent.

4. Galvanic optocoupler structure (10) according to claim 1, **characterised in that** said optical source (3) comprises at least one anode (31) and one cathode (35) enclosing at least one emissive layer (34) suitable for generating said optical signal, at least said anode (31) being realised directly on said optical substrate (4) in a material being transparent with respect to said optical signal.

5. Galvanic optocoupler structure (10) according to claim 4, **characterised in that** it further comprises, on said anode (31), at least one hole carrying layer (32).

6. Galvanic optocoupler structure (10) according to claim 5, **characterised in that** it further comprises, on said hole carrying layer (32), at least one intermediate layer (33).

7. Galvanic optocoupler structure (10) according to claim 1, **characterised in that** it further comprises, below said transparent optical substrate (4), a polarising layer (41) suitable for imposing a particular colour to said optical signal.

8. Galvanic optocoupler structure (10) according to claim 1, **characterised in that** it further comprises, on said cathode (35), at least one further layer (36), realised in a material being transparent with respect to said optical signal.

9. Galvanic optocoupler structure (10) according to claim 1, **characterised in that** said optical substrate (4) is realised by an electrically insulating material.

10. Galvanic optocoupler structure (10) according to claim 1, **characterised in that** said optical detector (5) is chosen among a photodiode, a phototransistor or a photodarlington.

11. Galvanic optocoupler structure (10) according to claim 3, **characterised in that** said optical detector (5) further comprises, on said semiconductor substrate (51) and said active region (52), a protection layer (57), provided with at least one discontinuity (57a) in correspondence with said active region (52) suitable for housing said at least one contact portion (58a) of said active region (52).

12. Galvanic optocoupler structure (10) according to claim 11, **characterised in that** it further comprises a contacting layer (56) of said semiconductor substrate (51) in an opposite position with respect to said optical source (3).

13. Galvanic optocoupler structure (10) according to claim 2, **characterised in that** said adhesive material (11) comprises a bonding resin transparent with respect to said optical signal.

14. Galvanic optocoupler structure (10) according to claim 2, **characterised in that** said adhesive material (11) is arranged along a whole contact area (4d) between said optical substrate (4) and said optical detector (5).

15. Galvanic optocoupler structure (10) according to claim 14, **characterised in that** it comprises, in correspondence with said contact area (4d) between said optical substrate (4) and said optical detector (5), a polarising layer (41) suitable for imposing a particular colour to said optical signal.

16. Galvanic optocoupler structure (10) according to claim 4, **characterised in that** said emissive layer (34) is realised above said anode (31) so as to leave at least one contact portion (31a) of said anode (31) accessible.

17. Galvanic optocoupler structure (10) according to claim 4, **characterised in that** said emissive layer (34) comprises at least one organic or polymeric layer suitable for realising the emission of said optical signal.

18. Galvanic optocoupler structure (10) according to claim 4, **characterised in that** said cathode (35) comprises at least one contact portion (35a).

19. Galvanic optocoupler structure (10) according to claim 18, **characterised in that** said contact portion (35a) is realised in a portion of said cathode (35) in direct contact with said optical substrate (4).

20. Galvanic optocoupler structure (10) according to claim 4, **characterised in that** said anode (31) is realised by means of an ITO layer.

21. Galvanic optocoupler structure (10) according to claim 4, **characterised in that** said emissive layer (34) is realised by means of a LEP layer.

22. Galvanic optocoupler structure (10) according to claim 5, **characterised in that** said hole carrying layer (32) is realised by means of a PEDOT layer.

23. Galvanic optocoupler structure (10) according to claim 11, **characterised in that** said protection layer (57) is realised in a passivating dielectric material.

24. Hybrid integration process of a galvanic optocoupler structure (10) of the type comprising at least one optical source (3) coupled to an optical detector (5) and separated therefrom by a transmission means (4) of an optical signal, said process being **characterised in that** it comprises the following steps:
- realising said optical detector (5) provided with at least one active region (52) for the generation of a photocurrent;
- realising, on an optical substrate (4), said optical source (3) by means of an organic LED; and
- mechanically associating said optical source (3) with said active region (52) of said optical detector (5),
said optical substrate (4) of said optical source (3) being transparent with respect to said optical signal and serving as said transmission means (4) of said optical signal and by insulation means between said optical source (3) and said optical detector (5).

25. Hybrid integration process according to claim 24, **characterised in that** said step of mechanically associating said optical source (3) with said active region (52) of said optical detector (5) comprises a step of gluing said optical substrate (4) of said optical source (3) directly onto said active region (52) of said optical detector (5) by means of an adhesive material (11).

26. Hybrid integration process according to claim 25, **characterised in that** said step of gluing said optical substrate (4) of said optical source (3) directly onto said active region (52) of said optical detector (5) uses a transparent bonding resin as adhesive material (11).

27. Hybrid integration process according to claim 24, **characterised in that** said step of realising said optical detector (5) comprises the steps of:
- realising, in a semiconductor substrate (51), said active region (52); and
- realising, above said semiconductor substrate (51) and said active region (52), a protection layer (57) of said optical detector (5) provided with at least one discontinuity (57a).

28. Hybrid integration process according to claim 24, **characterised in that** said step of realising said optical source (3) comprises a step of realising, on said optical substrate (4), at least one anode (31) and one cathode (35) enclosing at least one emissive layer (34) of said optical signal.

29. Hybrid integration process according to claim 26, **characterised in that** it further comprises the steps of:
- positioning said optical substrate (4) of said optical source (3) on said protection layer (57) in a distinct position with respect to said at least one discontinuity (57a); and
- associating, through gluing, said optical substrate (4) of said optical source (3) with said protection layer (57) of said optical detector (5) by means of said adhesive material (11).

30. Hybrid integration process according to claim 27, **characterised in that** it further comprises a step of shaping said optical substrate (4) of said optical source (3) suitable for realising at least first and second peripheral areas (4a, 4b), interconnected to said protection layer (27) by means of said adhesive material (11).

31. Hybrid integration process according to claim 26, **characterised in that** it further comprises a step of realising a polarising layer (41) between said optical substrate (4) of said optical source (3) and said protection layer (57) of said optical detector (5).

32. Hybrid integration process according to claim 28, **characterised in that** said step of realising said optical source (3) further comprises the steps of:
- realising said anode (31) directly on said optical substrate (4);
- realising a hole carrying layer (32) on said anode (31) and having at least one portion in contact with said optical substrate (4);
- realising said emissive layer (34) above said hole carrying layer (32);
- realising said cathode (35) on said emissive layer (34) and having at least one portion in contact with said optical substrate (4).

33. Hybrid integration process according to claim 32, **characterised in that** it further comprises a step of realising an intermediate layer (33) between said hole carrying layer (32) and said emissive layer (34).

34. Hybrid integration process according to claim 32, **characterised in that** said step of realising said emissive layer (34) comprises a step of depositing an organic or polymeric layer suitable for realising the emission of an optical signal.

35. Hybrid integration process according to claim 32, **characterised in that** said step of realising said hole carrying layer (32) on said anode (31) is carried out so as not to overlap onto at least one portion of said anode (31).

36. Hybrid integration process according to claim 35, **characterised in that** it further comprises a step of realising suitable metallic pads (31a, 35a) on said anode (31) and said cathode (35) of said optical source (3), for their contacting.

37. Hybrid integration process according to claim 36, **characterised in that** said step of realising said metallic pads (35a) on said cathode (35) of said optical source (3) is realised in a portion of said cathode (35) in direct contact with said optical substrate (4).

38. Hybrid integration process according to claim 36 or 37, **characterised in that** it further comprises a step of contacting said metallic pads (31a, 35a) by means of respective bonding wires (31b, 35b).

39. Hybrid integration process according to claim 29, **characterised in that** it further comprises a step of realising at least one metallic pad (58a) in correspondence with said discontinuity (57a) of said protection layer (57) for contacting said active region (52) of said optical detector (5).

40. Hybrid integration process according to claim 39, **characterised in that** it further comprises a step of contacting said at least one metallic pad (58a) by means of at least one bonding wire (58b).
